# EUROPEAN PATENT APPLICATION

(11) **EP 4 411 812 A1**
(43) Date of publication of application: **07.08.2024**
(21) Application number: 22875459.4
(22) Date of filing: 03.06.2022
(51) Int. Cl.: H01L 23/473, H05K 7/20

(54) **COOLER FOR POWER DEVICE**

(30) Priority: 28.09.2021 JP 2021157632
(71) Applicant: Nikkeikin Almo Company, Ltd., Tokyo 105-8681 (JP); Nippon Light Metal Company, Ltd., Tokyo 105-8681 (JP)
(72) Inventor: SEKI, Kazuhito, Shizuoka-shi, Shizuoka 421-3297 (JP); HIRANO, Yutaka, Shizuoka-shi, Shizuoka 421-3297 (JP); HIRAYAMA, Tomoyuki, Tokyo 105-8681 (JP); OKAJIMA, Kazuya, Shizuoka-shi, Shizuoka 421-3297 (JP); SUZUKI, Kenta, Shizuoka-shi, Shizuoka 421-3291 (JP)
(74) Representative: TBK
(86) International application number: PCT/JP2022/022631
(87) International publication number: WO 2023/053580

(57) **Abstract**

To provide a cooling device for a power device that can be assembled easily with fewer parts, and that has a high heat exchanger performance. The cooling device comprises: a first casing member 10 as a plate member, a second casing member 20 as a frame member having a predetermined thickness, and a finned heat receiving plate 30 having a heat receiving surface 31a joined to an exothermic body, each of which are made of aluminum material. A coolant inlet 11 and a coolant outlet 12 are formed in the first casing member at positions to be opposed to each other. The second casing member has a thickness possible to prevent warpage thereof by a heat when joining an exothermic body, and in the second casing member, an inlet side coolant guide 21 communicated with the coolant inlet and an outlet side coolant guide 22 communicated with the coolant outlet are formed at positions to be opposed to each other. The finned heat receiving plate comprises fins 34 formed integrally on an inner surface of the heat receiving plate within a region corresponding to a coolant space 23, and each clearance between the adjoining fins serves as a flow passage 33. The first casing member, the second casing member, and the finned heat receiving plate are joined to one another, and the fins are also joined to the first casing member.

## Description

### Technical Field

The present invention relates to a cooling device for a power device, and more particularly, to a cooling device that is placed in contact with an exothermic body combined with a power device such as a power semiconductor to reduce heat emitted from the power device.

### Background Art

In recent years, a power semiconductor (or power device) that generates a large amount of heat is employed in hybrid vehicles, plug-in hybrid vehicles, electric vehicles, high-speed railway vehicles etc. so as to enhance a switching performance of a motor. Therefore, in order to actuate the power semiconductor (or power device) generating a large amount of heat in a stable manner, a cooling device having high heat exchanger performance and high reliability is in demand.

In the conventional art, a heat sink having a cooling fan is often used to cool exothermic bodies. However, a cooling performance of the cooling fan would be insufficient to cool the exothermic bodies generating a large amount of heat. To this end, therefore, a water cooling device and a liquid cooling jacket may be employed (c.f., Japanese Patent laid-open No. 2017-98439, and publications of Japanese Patent Nos. 6698111, 6508398, and 6314802).

In a cooling device described in Japanese Patent laid-open No. 2017-98439, a casing of a liquid-cooled cooler comprises: an upper component member serving as a top wall including an installation surface to which an exothermic body is attached; and a lower component member serving as a bottom wall and a peripheral wall. Pin fins are scattered entirety within an area enclosed by a coolant flow path between: a pair of inward protrusions protruding from the upper component member and an inlet side guide portion guiding coolant; and another pair of inward protrusions also protruding from the upper component member and an outlet side guide portion also guiding the coolant. Those pin fins are brazed with an upper surface of an outward flange serving as the bottom wall and the peripheral wall of the lower component member. According to the teachings of Japanese Patent laid-open No. 2017-98439, an insulating laminated material is brazed with the top wall having the installation surface to which the exothermic body is attached, and a warpage suppressing plate formed of material whose coefficient of linear expansion is lower than that of aluminum is brazed with an outer surface of the bottom wall. Therefore, the casing, the insulating laminated material, and the warpage suppressing plate will not be warped thermally even when the exothermic body is soldered thereto.

The liquid-cooled jackets described in Publications of Japanese Patent Nos. 6698111 and 6508398 individually comprise: a casing having a base plate and a frame member (or a peripheral wall portion); and a fin body including first fins and second fins. Each of the first fins and the second fins forms a plurality of zigzag plow passages. The first fins and the second fins are held in the casing, and the fin body is brazed with the casing. According to the teachings of Japanese Patent Nos. 6698111, 6508398, and 6314802, in the fin body, the first fins and the second fins are alternately juxtaposed in the front-rear direction i.e., a flowing direction of the coolant to form zigzag fins. To this end, the first fins and the second fins are cutout by a multiple cutter.

### Summary of Invention

### Technical Problem to be Solved by the Invention

As described, in the cooling device described in Japanese Patent laid-open No. 2017-98439, the pin fins are scattered entirety within the area enclosed by the coolant flow path between: the pair of inward protrusions protruding from the upper component member and the inlet side guide portion; and another pair of inward protrusions also protruding from the upper component member and the outlet side guide portion. Those pin fins are brazed with the upper surface of the outward flange serving as the bottom wall and the peripheral wall of the lower component member, and the warpage suppressing plate is brazed with the outer surface of the lower component member. Thus, a complex working is required to form the components, and an assembling work is rather difficult.

Whereas, in the liquid-cooled jackets described in Publications of Japanese Patent Nos. 6698111, 6508398, and 6314802, the casing having the base plate and the frame member (or a peripheral wall portion) is brazed with the fin body including first fins and second fins forming the zigzag plow passages held in the casing. Thus, a complex working is also required to form the components, and an assembling work would also be difficult.

The present invention has been conceived noting the foregoing technical problems, and it is therefore an object of the present invention to provide a cooling device for a power device that can be assembled efficiently with fewer parts, and that has a high heat exchanger performance.

### Means for Solving the Problem

In order to achieve the above-explained objectives, according to the present invention, there is provided a cooling device comprising a first casing member as a plate member, a second casing member as a frame member having a predetermined thickness, and a finned heat receiving plate having a heat receiving surface joined to an exothermic body. Each of those members are made of aluminum material. In the cooling device, a coolant inlet and a coolant outlet are formed in any one of the first casing member and the finned heat receiving plate at positions to be opposed to each other. The second casing member has the predetermined thickness possible to prevent warpage thereof by a heat when joining the exothermic body to the heat receiving surface. In the second casing member, an inlet side coolant guide communicated with the coolant inlet and an outlet side coolant guide communicated with the coolant outlet are formed at positions to be opposed to each other. The finned heat receiving plate comprises a plurality of fins formed integrally on an inner surface of the heat receiving plate within a region excluding a joint section that is to be joined to the second casing member. Each clearance between the adjoining fins serves as a flow passage. In addition, the first casing member, the second casing member, and the finned heat receiving plate are joined to one another, and the fins are joined to the first casing member. Here, definition of aluminum material includes aluminum alloy.

According to the above-explained configuration, therefore, the cooling device for the power device may be formed of three pieces such as: the first casing member as a plate member; the second casing member as a frame member having sufficient rigidity to prevent warpage thereof by a heat when joining the exothermic body to the heat receiving surface, and the finned heat receiving plate that reduces a resistance of heat transfer.

According to the present invention, the first casing member, the second casing member, and the finned heat receiving plate may be formed of aluminum material. For example, the second casing member may be manufactured by cutting an extruded aluminum material into a slice, or processing an aluminum forging material. Likewise, the finned heat receiving plate may also be manufactured by cutting an extruded aluminum material, or processing an aluminum forging material.

Given that the second casing member and the finned heat receiving plate are formed of the extruded aluminum material or the aluminum forging material, it is preferable to braze the first casing member, the second casing member, and the finned heat receiving plate with one another. To this end, it is more preferable to form a layer of brazing material on at least any one of the adjoining members to be brazed with each other. Instead, the brazing material may also be applied to at least any one of the members to be brazed with each other, or otherwise, a brazing plate, brazing powder, or a brazing rod may also be used to braze the adjoining members. Specifically, it is preferable to select the material of the first casing member, the second casing member, and the finned heat receiving plate from the group consisting of the 1000 series (pure aluminum) aluminum alloy, the 3000 series (Al-Mn series) aluminum alloy, the 6000 series (Al-Mg-Si series) aluminum alloy, and the 8000 series (Al-Fe series) aluminum alloy.

Thus, in the above-explained configuration, the first casing member, the second casing member, and the finned heat receiving plate are brazed to one another to be integrated. Therefore, air-tightness and rigidity of the cooling device may be insured.

In addition, given that the first casing member, the second casing member, and the finned heat receiving plate are made of the 6000 series (Al-Mg-Si series) aluminum alloy, it is preferable to braze those members with one another using flux containing cesium fluoride (CsF).

Consequently, an aluminum anodized film may be removed smoothly and the brazing material may be flown smoothly by the flux. For this reason, the above-mentioned members may be brazed easily.

### Advantageous Effects of Invention

Since the present invention is configured as has been described, the following advantages may be achieved.
(1) According to claim 1 of the present invention, the cooling device for the power device may be formed of three pieces such as: the first casing member as a plate member; the second casing member as a frame member having sufficient rigidity to prevent warpage thereof by a heat when joining the exothermic body to the heat receiving surface, and the finned heat receiving plate that reduces a resistance of heat transfer. Therefore, the number of components may be reduced, and the components may be processed and assembled efficiently. In addition, a heat exchanger performance of the cooling device may be enhanced.
(2) According to claims 2 to 4 of the present invention, the first casing member, the second casing member, and the finned heat receiving plate are brazed to one another to be integrated. Therefore, the air-tightness and the rigidity of the cooling device may be insured. For this reason, in addition to the advantage (1), a heat exchanger performance of the cooling device may be further enhanced and a longevity of the cooling device may also be enhanced.
(3) According to claim 5 of the present invention, the components of the cooling device may be brazed easily with one another. Therefore, in addition to the advantages (1) and (2), the components of the cooling device may be assembled efficiently. Further, the heat exchanger performance of the cooling device may be further enhanced and the longevity of the cooling device may also be enhanced.

### Brief Description of Drawings

[Fig. 1] is a plan view showing a partial cross-section of the cooling device according to the first embodiment of the present invention being in use.
[Fig. 2] is a cross-sectional view along the I-I line drawn in Fig. 1.
[Fig. 3] is a cross-sectional view along the II-II line drawn in Fig. 1.
[Fig. 4] (a) is a cross-sectional view along the III-III line drawn in Fig. 1 and (b) is an enlarged view of a section IV shown in Fig. 4 (a).
[Fig. 5] is an exploded perspective view showing a first casing member, a second casing member, and a fined heat receiving plate according to the first embodiment.
[Fig. 6] is a plan view showing a partial cross-section of the cooling device according to the second embodiment of the present invention being in use.
[Fig. 7] is a cross-sectional view along the V-V line drawn in Fig. 6.
[Fig. 8] is a cross-sectional view along the VI-VI line drawn in Fig. 6.
[Fig. 9] is an exploded perspective view showing the first casing member, the second casing member, and the finned heat receiving plate according to the second embodiment.
[Fig. 10] is a perspective view showing one example of a forming material of the finned heat receiving plate before forming fins.
[Fig. 11] is a perspective view showing another example of the forming material of the finned heat receiving plate before processing.

### Description of Embodiment(s)

Hereinafter, embodiments of the cooling device according to the present invention will be described in detail with reference to the accompanying drawings.

### <First Embodiment>

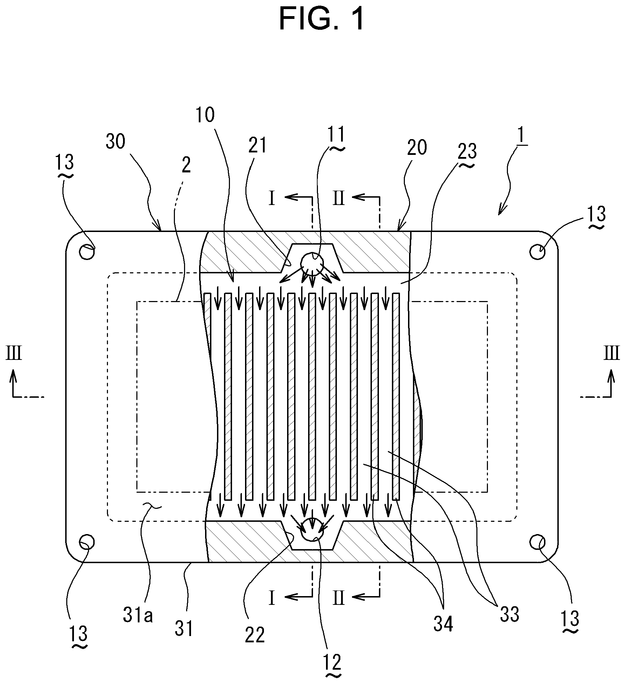

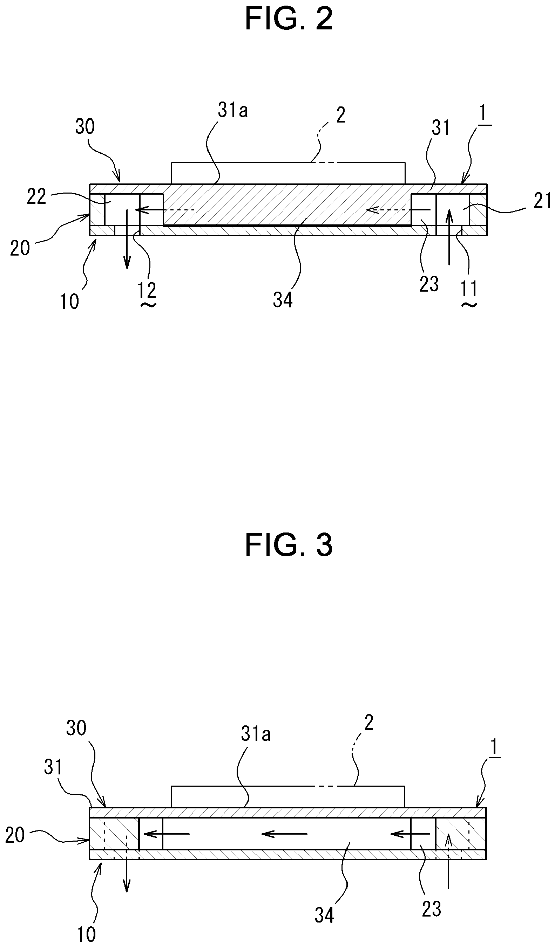

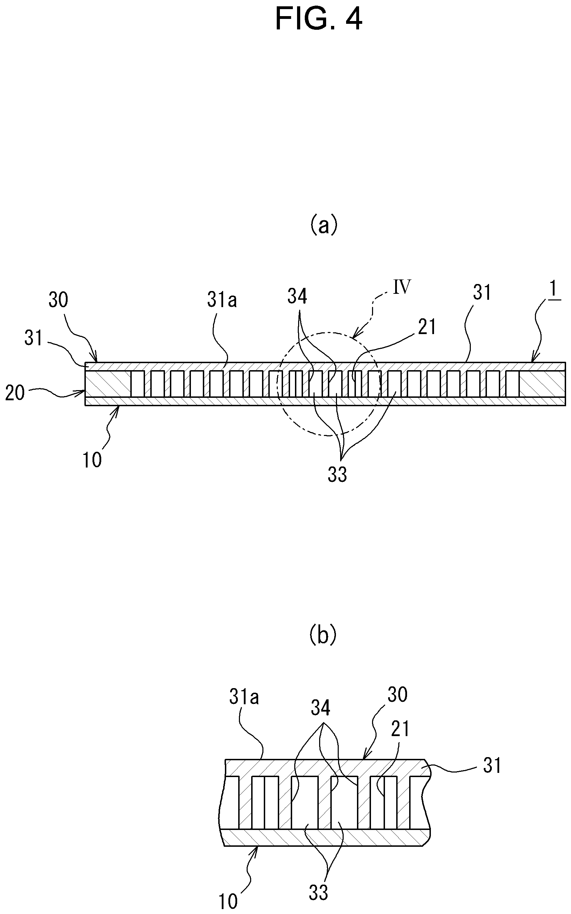

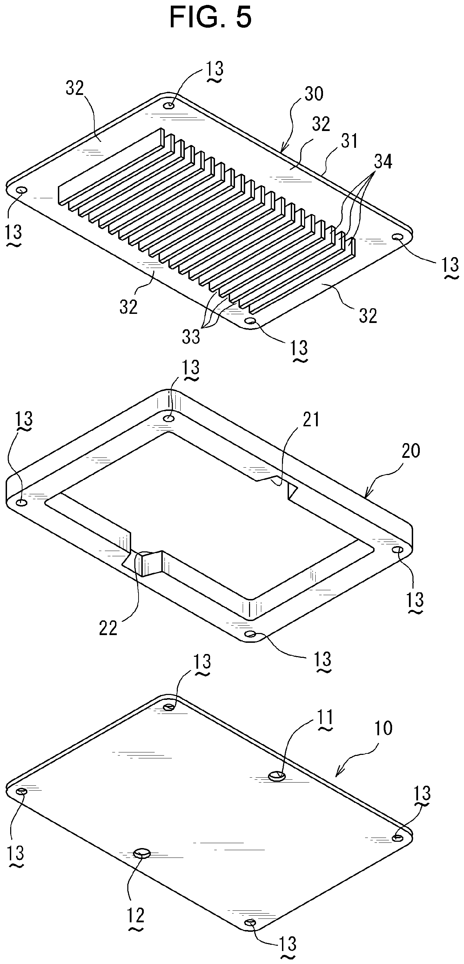

As illustrated in Figs. 1 to 5, a cooling device 1 according to the present invention is a stack of: a first casing member 10 as a plate member; a second casing member 20 as a frame member having a same contour as the first casing member 10 and a predetermined thickness; and a finned heat receiving plate 30 having a heat receiving surface 31a. A power module 2 in which a power device as an exothermic body e.g., a power semiconductor is arranged is joined to the heat receiving surface 31a. The first casing member 10, the second casing member 20, and the finned heat receiving plate 30 are made of aluminum. Here, definition of aluminum includes aluminum alloy.

The first casing member 10 is formed by pressing a rounded rectangular aluminum plate in which corners are chamfered. In the first casing member 10, a coolant inlet 11 is formed at a longitudinally intermediate position of the first casing member 10 in the vicinity of one of the long sides, and a coolant outlet 12 is formed in the vicinity of the other one of the long sides at a position to be opposed to the coolant inlet 11 in the short direction of the first casing member 10. In addition, a locating hole 13 is formed in the vicinity of each of the four corners. However, it is not necessary to form the locating hole 13 in the vicinity of each of the four corners. For example, the locating holes 13 may be formed only in the vicinity of the diagonally opposing two corners.

The second casing member 20 has a sufficient thickness so that it will not be warped by the heat when joining the power module 2 to the cooling device 1. In the second casing member 20, an inlet side coolant guide 21 and an outlet side coolant guide 22 are formed at positions to be opposed to each other in the short direction of the second casing member 20. Specifically, the inlet side coolant guide 21 is formed in the vicinity of the one of the long sides of the second casing member 20 at a position to be communicated with the coolant inlet 11, and the outlet side coolant guide 22 is formed in the vicinity of the other one of the long sides to be communicated with the coolant outlet 12. The inlet side coolant guide 21 and the outlet side coolant guide 22 are communicated with a coolant space 23 enclosed by the second casing member 20. Specifically, in order to spread the coolant entirely within the coolant space 23, each of the inlet side coolant guide 21 and the outlet side coolant guide 22 is shaped into a trapezoidal recess opening widely toward the coolant space 23.

The second casing member 20 may be formed by merely cutting an extruded aluminum material into a slice having a desired thickness. Instead, the second casing member 20 may also be formed by processing an aluminum forging material. In the case of using the forging material, the second casing member 20 may be formed using e.g., a mechanical press machine having a forging die.

In the finned heat receiving plate 30, a plurality of fins 34 are formed integrally on an inner surface of a heat receiving plate 31 within a region excluding a joint section 32 that is to be joined to the second casing member 20, that is, within a region corresponding to the coolant space 23. Each clearance between the adjoining fins 34 serves as a flow passage 33.

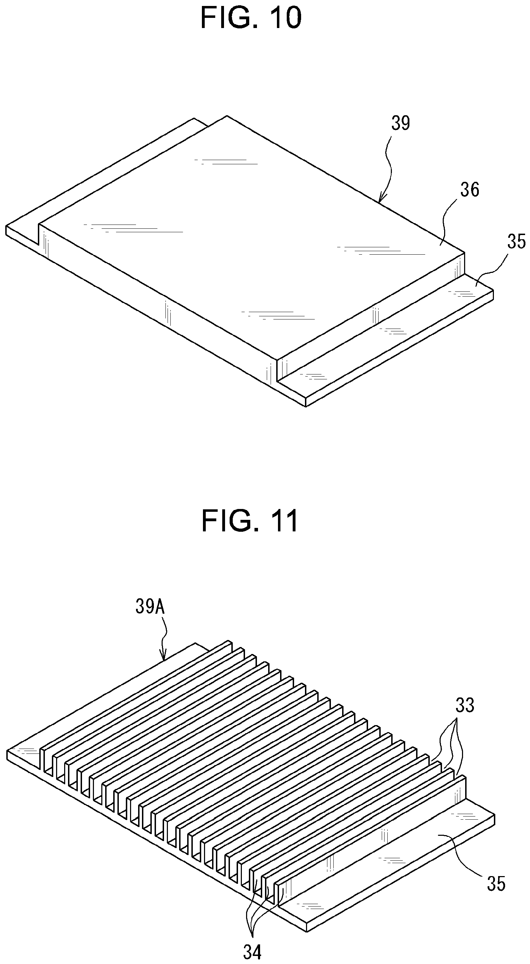

For example, the finned heat receiving plate 30 may be formed by processing a forming material 39 shown in Fig. 10 that is prepared by cutting an extruded aluminum material into a designed dimension of the cooling device 1. The forming material 39 comprises a finned section 36 as a plateau section formed on a flat section 35 serving as the heat receiving plate 31, and the joint sections 32 expanding on both longitudinal ends of the flat section 35. Specifically, the finned heat receiving plate 30 is formed (or manufactured) by cutting the finned section 36 of the forming material 39 to form the fins 34 using a multi cutter (not shown) in which a plurality of disc cutters are juxtaposed, and consequently the flow passage 33 are formed between the adjoining fins 34. Thereafter, both end sections of the fins 34 are cut out in the direction perpendicular to the joint sections 32 expanding on the longitudinal ends of the flat section 35, thereby forming the joint sections 32 along the long sides of the finned heat receiving plate 30. Instead, the fins 34 may also be formed by the multi cutter after forming the joint sections 32 along the long sides of the finned heat receiving plate 30.

Alternatively, the finned heat receiving plate 30 may also be formed by processing another forming material 39A shown in Fig. 11 that is also prepared by cutting an extruded aluminum material into a designed dimension of the cooling device 1. In the forming material 39A, the fins 34 are already formed on the flat section 35 serving as the heat receiving plate 31, and the joint sections 32 are formed on the longitudinal ends of the flat section 35. In this case, the finned heat receiving plate 30 is formed (or manufactured) by cutting out the end sections of the fins 34 in the direction perpendicular to the joint sections 32 expanding on the longitudinal ends of the flat section 35, thereby forming the joint sections 32 along the long sides of the finned heat receiving plate 30.

Otherwise, the finned heat receiving plate 30 may also be formed by processing an aluminum forging material. In the case of using the forging material, the finned heat receiving plate 30 may be formed using e.g., a mechanical press machine having a forging die.

The first casing member 10 as a plate member, the second casing member 20 as a frame member having a predetermined thickness, and the finned heat receiving plate 30 may be formed of brazable aluminum alloy selected from the group consisting of the 1000 series (pure aluminum), the 3000 series (Al-Mn series), the 6000 series (Al-Mg-Si series), and the 8000 series (Al-Fe series).

In this embodiment, the first casing member 10, the second casing member 20, and the finned heat receiving plate 30 are made of the 6000 series (Al-Mg-Si series) aluminum alloy e.g., A6063 aluminum alloy. Specifically, A6063 aluminum alloy contains, in terms of weight percent, 0.6% of Si, 0.35% of Fe, 0.1% of Cu, 0.1% of Mn, 0.9% of Mg, 0.1% of Cr, 0.1% of Zn, and 0.01% of Ti, and the remaining contents of A6063 aluminum alloy is Al and unavoidable impurities. Instead, the first casing member 10 may also be manufactured from material other than A6063 aluminum alloy such as a brazing sheet using A6063 aluminum alloy as a core material.

In the case that the first casing member 10, the second casing member 20, and the finned heat receiving plate 30 are made of the 6000 series (Al-Mg-Si series) aluminum alloy, those members are brazed with one another using flux containing cesium fluoride (CsF). In this case, the flux is applied to each joint surface between the first casing member 10 and the second casing member 20, and between the second casing member 20 and the finned heat receiving plate 30. A reaction of the flux containing cesium fluoride (CsF) commences at a relatively low temperature compared to the conventional Nocolok flux. Therefore, in a case of brazing alloy material containing Mg, the brazing quality will not be affected severely by deposition of Mg.

Thus, the cooling device 1 is formed by brazing the first casing member 10, the second casing member 20, and the finned heat receiving plate 30 with one another, and in the cooling device 1, longer edges of the fins 34 are also joined to an inner surface of the first casing member 10. To this end, for example, a layer of brazing material is formed on at least any one of the adjoining members to be brazed with each other. Instead, the brazing material may also be applied to at least any one of the members to be brazed with each other, or otherwise, a brazing plate, brazing powder, or a brazing rod may also be used to braze the adjoining members. An assembly of the first casing member 10, the second casing member 20, and the finned heat receiving plate 30 in which the layer of the brazing material, the brazing plate, the brazing powder, or the brazing rod is interposed between each of the adjoining members is heated in a furnace at a predetermined temperature to braze the adjoining members with each other.

In order to attach the power module 2 to the cooling device 1 manufactured by the above-explained procedures, residual flux is removed from the heat receiving surface 31a of the finned heat receiving plate 30. Thereafter, the heat receiving surface 31a is plated with Ni, and the power module 2 is soldered to the heat receiving surface 31a. For example, the residual flux may be removed by applying abrasive agent together with liquid (water) to the heat receiving surface 31a at high speed by a compressed air using a wet blaster. As described, the heat receiving surface 31a is coated with a nickel finish.

In the cooling device 1 having the above-explained structure, the coolant supplied from the coolant inlet 11 flows into the coolant space 23 via the inlet side coolant guide 21. The coolant further flows through the flow passages 33 formed between the adjoining fins 34 formed integrally on the inner surface of the heat receiving plate 31 toward the outlet side coolant guide 22, and eventually drained from the coolant outlet 12. Consequently, the power module 2 that is heated by the heat generated by the power device and that is joined to the heat receiving surface 31a may be cooled efficiently.

In the foregoing embodiment, the coolant inlet 11 and the coolant outlet 12 are formed in the first casing member 10. However, it is to be noted that the coolant inlet 11 and the coolant outlet 12 may also be formed in the heat receiving plate 31 of the finned heat receiving plate 30.

### <Second Embodiment>

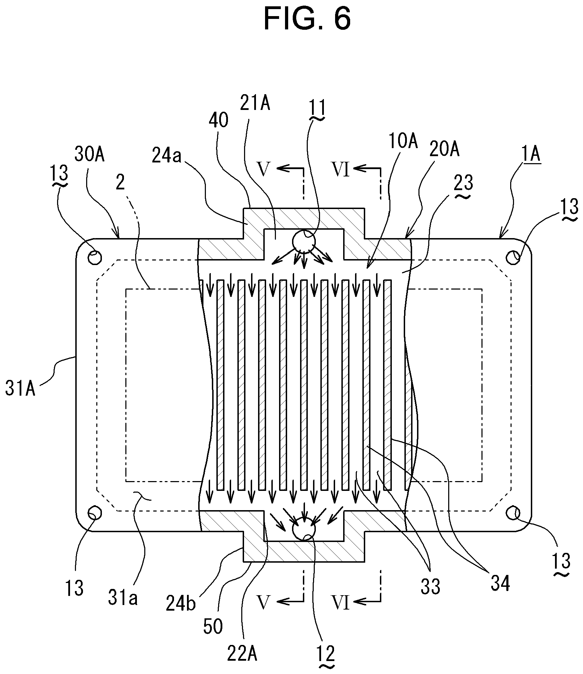

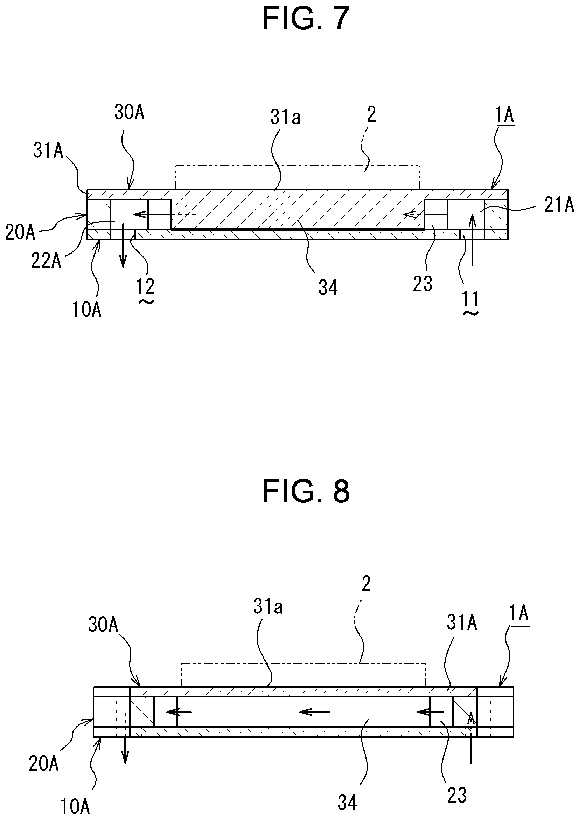

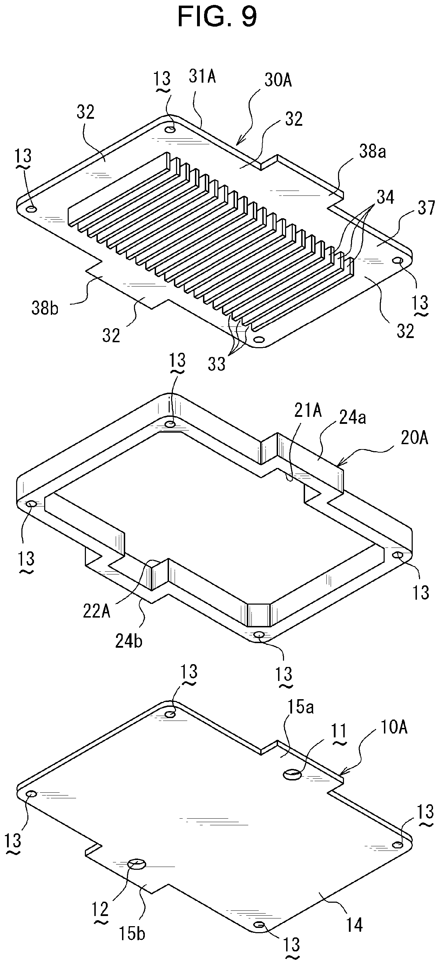

As illustrated in Figs. 6 to 9, in a cooling device 1A according to the second embodiment, a coolant inlet section 40 and a coolant outlet section 50 are opposed to each other in the short direction of the cooling device 1A outside of a rectangular base section.

The cooling device 1A according to the second embodiment is a stack of: a first casing member 10A as a plate member; a second casing member 20A as a frame member having a same contour as the first casing member 10A and a predetermined thickness; and a finned heat receiving plate 30A having a heat receiving surface 31a. The first casing member 10A comprises a rectangular base section 14: and a pair of rectangular expanded sections 15a and 15b opposed to each other in the short direction of the base section 14. Specifically, one of the expanded sections 15a expands outward from an intermediate position of one of the long sides of the base section 14, and the other one of the expanded sections 15b expands outward from an intermediate position of the other one of the long sides of the base section 14. The power module 2 in which the power device as an exothermic body e.g., a power semiconductor is arranged is joined to the heat receiving surface 31a.

The first casing member 10A is formed by pressing an aluminum plate material having the rectangular base section 14 in which the corners are chamfered, and the expanded sections 15a and 15b opposed to each other in the short direction of the base section 14 expand outward from the intermediate positions of the long sides of the base section 14. In the first casing member 10A, the coolant inlet 11 is formed in one of the expanded sections 15a expanding outward from the longitudinally intermediate position of the base section 14, and the coolant outlet 12 is formed in the other one of the expanded sections 15b opposed to the expanded section 15a. Here, configurations of the expanded sections 15a and 15b should not be limited to the rectangular shape. For example, the expanded sections 15a and 15b may also be shaped into an arcuate shape or a semi-elliptical shape.

The second casing member 20A has a sufficient thickness so that it will not be warped by the heat when joining the power module 2 to the cooling device 1. In the second casing member 20A, a pair of rectangular expanded frame sections 24a and 24b are formed at positions to be opposed to each other in the short direction of the second casing member 20A. Specifically, one of the expanded frame sections 24a protrudes outward from an intermediate position of one of long sides of the second casing member 20A, and the other one of the expanded frame sections 24b protrudes outward from an intermediate position of the other one of the long sides of the second casing member 20A. An inlet side coolant guide 21A is formed in the expanded frame section 24a to be communicated with the coolant inlet 11, and an outlet side coolant guide 22A is formed in the expanded frame section 24b to be communicated with the coolant outlet 12. The inlet side coolant guide 21A and the outlet side coolant guide 22A are individually communicated with the coolant space 23 enclosed by the second casing member 20A. The second casing member 20A may also be manufactured by the same procedure as the procedure of forming the second casing member 20 according to the first embodiment. That is, the second casing member 20A may also be formed by merely cutting an extruded aluminum material into a slice having a desired thickness. Instead, the second casing member 20A may also be formed by processing an aluminum forging material.

The finned heat receiving plate 30A comprises: a rectangular heat receiving section 37; the heat receiving plate 31A; a pair of rectangular expanded sections 38a and 38b; and a plurality of fins 34. Specifically, the rectangular expanded sections 38a and 38b are opposed to each other in the short direction of the heat receiving plate 37. One of the expanded sections 38a expands outward from an intermediate position of one of the long sides of the heat receiving plate 37, and the other one of the expanded sections 38b expands outward from an intermediate position of the other one of the long sides of the heat receiving plate 37. The fins 34 are formed integrally on an inner surface of the heat receiving plate 31A within a region excluding the joint section 32 that is to be joined to the second casing member 20A, that is, within a region corresponding to the coolant space 23. Each clearance between the adjoining fins 34 serves as the flow passage 33. The finned heat receiving plate 30A may also be manufactured by the same procedure as the procedure of forming the finned heat receiving plate 30 according to the first embodiment. That is, the finned heat receiving plate 30A may also be formed by cutting an extruded aluminum material or processing an aluminum forging material.

Thus, according to the second embodiment, the expanded section 15a of the first casing member 10A, the expanded frame section 24a of the second casing member 20A, and the expanded section 38a of the finned heat receiving plate 30A are combined to serve as the coolant inlet section 40. Likewise, the expanded section 15b of the first casing member 10A, the expanded frame section 24b of the second casing member 20A, and the expanded section 38b of the finned heat receiving plate 30A are combined to serve as the coolant outlet section 50. In the second embodiment, the coolant inlet 11 is formed in the expanded section 15a of the first casing member 10 and the coolant outlet 12 formed in the expanded section 15b of the first casing member 10. However, it is to be noted that the coolant inlet 11 may also be formed in the expanded section 38a of the heat receiving plate 31A of the finned heat receiving plate 30A, and the coolant outlet 12 may also be formed in the expanded section 38b of the heat receiving plate 31A of the finned heat receiving plate 30A.

According to the second embodiment, the remaining structures are similar to those of the first embodiment. Therefore, detailed explanations for the elements in common with those in the first embodiment will be omitted.

In the cooling device 1A having the above-explained structure, the coolant supplied from the coolant inlet 11 flows into the coolant space 23 via the coolant inlet section 40. The coolant further flows through the flow passages 33 formed between the adjoining fins 34 formed integrally on the inner surface of the heat receiving plate 31A toward the coolant outlet section 50, and eventually drained from the coolant outlet 12. Consequently, the power device 2 that is heated by the heat generated by the power device and that is joined to the heat receiving surface 31a may be cooled efficiently.

The cooling device 1 according to the first embodiment are formed by brazing the first casing member 10 as a plate member, the second casing member 20 as a frame member, and the finned heat receiving plate 30 to one another. Likewise, the cooling device 1A according to the second embodiment are formed by brazing the first casing member 10A as a plate member, the second casing member 20A as a frame member, and the finned heat receiving plate 30A to one another. As described, the second casing members 20 and 20A individually have a sufficient thickness to ensure rigidity thereof possible to prevent warpage thereof even when joining the power module 2 to the cooling device 1, and the finned heat receiving plates 30 and 30A individually have a configuration to reduce a resistance of heat transfer. Therefore, the number of components may be reduced, and the components may be processed and assembled efficiently. In addition, since the components are brazed to one another, air-tightness and rigidity of the cooling device may be insured. For this reason, a heat exchanger performance and a longevity of the cooling device may be enhanced.

In the foregoing embodiments, the first casing member 10, the second casing member 20, and the finned heat receiving plate 30 are made of the 6000 series (Al-Mg-Si series) aluminum alloy e.g., A6063 aluminum alloy. However, the above-explained advantages may also be achieved in a case of manufacturing those members using any of the 1000 series (pure aluminum), the 3000 series (Al-Mn series), and the 8000 series (Al-Fe series) brazable aluminum alloy.

## Claims

1. A cooling device for a power device, comprising:
a first casing member as a plate member, a second casing member as a frame member having a predetermined thickness, and a finned heat receiving plate having a heat receiving surface joined to an exothermic body, each of which are made of aluminum material; and
a coolant inlet and a coolant outlet formed in any one of the first casing member and the finned heat receiving plate at positions to be opposed to each other,
wherein the second casing member has the predetermined thickness possible to prevent warpage thereof by a heat when joining the exothermic body to the heat receiving surface, and an inlet side coolant guide communicated with the coolant inlet and an outlet side coolant guide communicated with the coolant outlet are formed in the second casing member at positions to be opposed to each other,
the finned heat receiving plate comprises a plurality of fins formed integrally on an inner surface of the heat receiving plate within a region excluding a joint section that is to be joined to the second casing member, and each clearance between the adjoining fins serves as a flow passage, and
the first casing member, the second casing member, and the finned heat receiving plate are joined to one another, and the fins are joined to the first casing member.

2. The cooling device for the power device as claimed in claim 1, wherein the first casing member, the second casing member, and the finned heat receiving plate are brazed with one another.

3. The cooling device for the power device as claimed in claim 2, wherein the first casing member, the second casing member, and the finned heat receiving plate are brazed with one another while forming a layer of brazing material on at least any one of the adjoining members to be brazed with each other, applying brazing material to at least any one of the adjoining members to be brazed with each other, or using a brazing plate, brazing powder, or a brazing rod.

4. The cooling device for the power device as claimed in claim 2 or 3, wherein the first casing member, the second casing member, and the finned heat receiving plate are made of aluminum alloy selected from the group consisting of the 1000 series (pure aluminum), the 3000 series (Al-Mn series), the 6000 series (Al-Mg-Si series), and the 8000 series (Al-Fe series).

5. The cooling device for the power device as claimed in claim 4, wherein the first casing member, the second casing member, and the finned heat receiving plate are brazed with one another using flux containing cesium fluoride (CsF), in a case that the first casing member, the second casing member, and the finned heat receiving plate are made of the 6000 series (Al-Mg-Si series) aluminum alloy.
